# EUROPEAN PATENT SPECIFICATION

(11) **EP 1 675 211 B1**
(45) Date of publication and mention of the grant of the patent: **17.04.2019**
(21) Application number: 04772935.5
(22) Date of filing: 06.09.2004
(51) Int. Cl.: H01G 9/20

(54) **ELECTROLYTE COMPOSITION AND PHOTOELECTRIC CONVERTER USING SAME**
ELEKTROLYT-ZUSAMMENSETZUNG UND FOTOELEKTRISCHER UMSETZER DAMIT
COMPOSITION D'ELECTROLYTE ET CONVERTISSEUR PHOTOELECTRIQUE UTILISANT CETTE COMPOSITION

(30) Priority: 08.09.2003 JP 2003315955
(43) Date of publication of application: 28.06.2006
(73) Proprietor: FUJIKURA LTD., Koto-ku Tokyo 135-8512 (JP)
(72) Inventor: WATANABE, Masayoshi Yokohama National University, Yokohama-shi Kanagawa 240-8501 (JP); KAWANO, Ryuji Yokohama National University, Yokohama-shi Kanagawa 240-8501 (JP); MATSUYAMA, Chizuru Yokohama National University, Yokohama-shi Kanagawa 240-8501 (JP); MATSUI, Hiroshi, Tokyo 135-8512 (JP); TANABE, Nobuo, Tokyo 135-8512 (JP)
(74) Representative: Cabinet Plasseraud
(86) International application number: PCT/JP2004/013253
(87) International publication number: WO 2005/024992

(56) References cited:
- EP-A- 1 473 745
- EP-A1- 0 718 288
- JP-A- 2004 227 909
- JP-A- 2004 241 378
- D. R. MACFARLANE, J. GOLDING, S. FORSYTH, G. B. DEACON: "Low viscosity ionic liquids based on organic salts of the dicyanamide anion" CHEM. COMMUN., 2001, pages 1430-1431, XP002426913
- PAPAGEORGIOU N ET AL: "The Performance and Stability of Ambient Temperature Molten Salts for Solar Cell Applications" JOURNAL OF THE ELECTROCHEMICAL SOCIETY, ELECTROCHEMICAL SOCIETY. MANCHESTER, NEW HAMPSHIRE, US, vol. 143, no. 10, October 1996 (1996-10), pages 3099-3108, XP002118482 ISSN: 0013-4651
- P. WANG, S. M. ZAKEERUDDIN, J.-E. MOSER, M. GRÄTZEL: "A new ionic liquid electrolyte enhances the conversion efficiency of dye sensitized solar cells" J. PHYS. CHEM. B, vol. 107, 6 November 2003 (2003-11-06), pages 13280-13285, XP002426915
- MACFARLANE D.R. ET AL.: 'Low viscosity ionic liquids based on organic salts of the dicyanamide anion' CHEM. COMMUN. no. 16, 21 August 2001, pages 1430 - 1431, XP002298931

## Description

### TECHNICAL FIELD

The present invention relates to an electrolyte composition and a photoelectric conversion element utilizing the same.

### BACKGROUND ART

Dye-sensitized solar cells which were developed by Graetzel et al. in Switzerland have advantages, such as higher photoelectric conversion efficiency and lower cost, and are attracting attention as new types of solar cells (see, Japanese Patent No. 2664194, and Japanese Unexamined Patent Application, First Publications Nos. 2001-160427, 2001-230434, and 2002-184478, for example).

The typical structure of dye-sensitized solar cells comprises a transparent conductive electrode substrate, a working electrode formed on the electrode substrate which has a porous film made of oxide semiconductor fine particles (nanoparticles), such as titanium dioxide, and having a photo-sensitizing dye absorbed thereon, a counter electrode provided opposing the working electrode, and an electrolyte containing redox pair filled between the working electrode and the counter electrode.

Such a dye-sensitized solar cell functions as a photoelectric conversion element that converts light energy into electricity when the oxide semiconductor fine particles are sensitized by the photo-sensitizing dye that absorbs incident light, such as sunlight, thereby generating an electromotive force between the working electrode and the counter electrode.

As the electrolyte, an electrolyte solution is typically used in which redox pair, such as I/I3<->, is dissolved in a typical organic solvent, such as acetonitrile. Other well-known electrolytes include one using a nonvolatile ionic liquid, one in which the liquid electrolyte is gelated using an appropriate gelator to be quasi-solidified, and one using a solid semiconductor, such as a p-type semiconductor.

However, when an organic solvent, such as acetonitrile or the like, is used for preparation of the electrolyte solution, a sufficient conductivity may not be ensured across the electrodes if the amount of the electrolyte solution is reduced due to volatilization of this organic solvent, resulting in a reduction in the photoelectric conversion characteristic. Accordingly, it may difficult to ensure a sufficient life time if such a solar cell is used, particularly outside. Example of related prior art can be found also in article by D.R. Macfarlane at el. "Low viscosity ionic liquids based on organic salts of the dicyanamide anion". Said article is related to new families of salts viz. quaternary ammonium. Article by Papageorgiou N. et al. "The performance and stability of ambient temperature molten salts for solar cell applications" is related to room temperature molten salts systems that appear to afford particular advantages over organic liquids as solvents for solar cell electrolytes. European patent application no. 1473745 discloses a dye sensitized solar cell where the dye is an amphiphilic ruthenium polypyridil complex and a stabilizing compound comprises a hydrophobic part and an anchoring group. EP0718288 is related to hydrophobic, liquid and low-viscosity salts for electrochemical or synthetic applications.

Another issue may arise when a nonvolatile ionic liquid is used as the electrolyte material although such an electrolyte solution can prevent volatilization of the solution. Since nonvolatile ionic liquids have a high viscosity, the charge transfer rate in the electrolyte is lower and thus the output of devices may be decreased when compared with a case in which a volatile electrolyte solution is used. Although some efforts have been made in order to increase the redox carrier concentration for achieving an improvement in the output current, they have not led to any significant fruitful results. Furthermore, the issue of a lower voltage is generally to be rectified.

### DISCLOSURE OF INVENTION

The present invention was conceived in light of the above-described circumstances, and an object thereof is to provide an electrolyte composition that provides excellent performance and a photoelectric conversion element utilizing the same.

In order to solve the above problem, the present invention provides an electrolyte composition comprising ionic liquid including dicyanamide anions as anions. Examples of cations of the ionic liquid may include, for example, cations having quaternized nitrogen atom.

The electrolyte composition according to the present invention may include halogen-based redox pair. Preferred applications of the electrolyte composition according to the present invention may include, for example, an electrolyte for a photoelectric conversion element.

Furthermore, the present invention provides a photoelectric conversion element comprising the above-described electrolyte composition as an electrolyte. Examples of such a photoelectric conversion element may include, for example, a dye-sensitized solar cell.

Since the electrolyte composition according to the present invention has excellent characteristics, it may be used for various applications as an electrolyte. When the electrolyte composition according to the present invention is used as an electrolyte for a photoelectric conversion element, it is possible to achieve a good photoelectric conversion characteristic since it can realize both a high current characteristic and a high voltage characteristic.

### BRIEF DESCRIPTION OF THE DRAWINGS

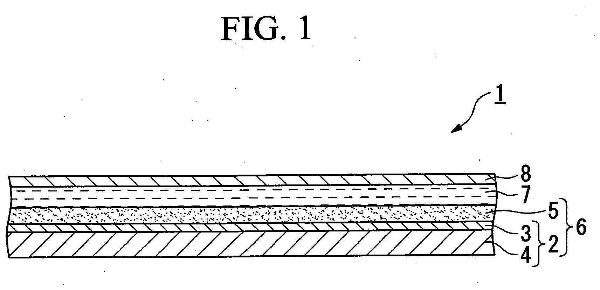

FIG. 1 is a cross-sectional view illustrating an example of a photoelectric conversion element according to the present invention.

### BEST MODE FOR CARRYING OUT THE INVENTION

Preferred embodiments of the invention will be described with reference to the drawings. However, it should not be construed that the present invention is limited to the below-mentioned embodiments; rather, components of those embodiments, for example, may be combined if necessary.

The present invention will now be described in detail based on preferred embodiments.

The electrolyte composition according to the present invention includes ionic liquid including dicyanamide anions as anions.

The ionic liquid is not particularly limited as long as it contains dicyanamide anions as anions, and room temperature molten salts that are liquid at room temperature may be used. Examples of counter cations for the dicyanamide anions may include, for example, cations having quaternized nitrogen atom.

Cations having quaternized nitrogen atom (hereinafter referred to as "cations having quaternary nitrogen atom") are quaternary ammonium (N⁺R¹R²R³R⁴; where R¹ to R⁴ are substituent groups, such as an alkyl group, a cycloalkyl group, an aryl group, an aralkyl group, or the like, and a part or all of the hydrogen atom(s) of the substituent group may be substituted); or cations of nitrogen-containing heterocyclic compounds, such as imidazolium, pyridinium, pyrrolidinium, pyrazolidinium, isothiazolidinium, isoxazolidinium, or the like. The cations having quaternary nitrogen atom may include substituent group combined to quaternized nitrogen atom or different atom of the ring, such as alkyl group, cycloalkyl group, aryl group, aralkyl group, or the like, as substituent group.

Concrete examples of ionic liquids containing dicyanamide anions are 1-ethyl-3-methylimidazolium dicyanamide, N-butylpyridinium dicyanamide, N-ethyl-N-methyl pyrrolidinium dicyanamide, N-propyl-N-methyl pyrrolidinium dicyanamide, N-butyl-N-methyl pyrrolidinium dicyanamide, N-hexyl-N-methyl pyrrolidinium dicyanamide, N-pentyl-N, N, N-triethyl ammonium dicyanamide, N-hexyl-N, N, N-triethyl ammonium dicyanamide, N-pentyl-N, N, N-tributyl ammonium dicyanamide, or the like.

Methods for synthesizing such ionic liquid include, for example, a method based on anion exchange of a salt having a cation having quaternary nitrogen atom using a dicyanamide salt of metal, such as sodium dicyanamide, silver dicyanamide, or the like. The synthesis method according to the anion exchange is described in, for example, Green Chemistry, 2002, Vol. 4, pp. 444-448.

Redox pairs may be added to the electrolyte composition according to the present invention, although they are not an essential component. It is preferable to add redox pair when the electrolyte composition is used in a dye-sensitized solar cell or the like.

As the redox pair, halogen-based redox pair made of halide ions, such as iodide ions (I⁻), bromide ions (Br⁻), or chloride ions (Cl⁻), and polyhalide ions, such as Br₃⁻, I₃⁻, I₅⁻, I₇⁻, Cl₂I⁻, ClI₂⁻, Br₂I⁻, BrI₂⁻, is preferably used, although these are not limiting.

Halogen-based redox pairs can be obtained by making halide ions, such as Cl⁻, Br⁻, I⁻, or the like, react with halogen molecules. As the halogen molecules, elemental halogen molecules, such as Cl₂, Br₂, I₂, or the like, and/or inter-halogen compounds, such as CII, BrI, BrCl, or the like, may be used. In more concrete terms, iodine / iodide ions or bromine / bromide ions may be exemplified.

The ratio of the halogen molecule with respect to the halide ion is not particularly limited, and, the molar ratio is more preferably between 0% and 100%. Although the addition of halogen molecules is not essential, it is preferable to add halogen molecules since the halide ions and the polyhalide ion may form redox pair in the presence of polyhalide ions, which may improve characteristics, such as the photoelectric conversion characteristic.

For the supply source of the halogen ions, a lithium salt, quaternary imidazolium salt, tetrabutylammonium salt, and the like may be used alone or in combination.

The electrolyte composition according to the present invention may be a gel that is gelated physically or chemically using an appropriate gelator.

Various additives may be added to the electrolyte composition according to the present invention if necessary in an amount in which the properties and characteristics of the electrolyte composition are not interfered with, and such additives may include, for example, organic nitrogen compounds such as 4-*tert*-butylpyridine, 2-vinylpyridine, N-vinyl-2-pyrrolidone, or the like; a lithium salt, a sodium salt, a magnesium salt, an iodide salt, a thiocyanate salt, water, or the like.

The methods for preparing the electrolyte composition of the present invention from the components described above are not particularly limited, and a method may be employed, for example, in which an electrolyte solution is obtained by adding additives, such as redox pair, to ionic liquid and uniformly mixing it.

The electrolyte composition of the present invention is preferably used as an electrode for photoelectric conversion elements, such as dye-sensitized solar cells, for example. Since ionic liquid including dicyanamide anions as the anions has lower viscosity than conventional ionic liquids, it can be expected that it will exhibit effects such as improving the charge transfer rate in the electrolyte. Furthermore, this electrolyte composition is characteristics in that a dye-sensitized solar cell using the electrolyte composition provides a higher electromotive force (open-circuit voltage) when compared with the case in which other ionic liquids are used.

It is believed that the electrolyte composition may be used for various applications in fields other than photoelectric conversion elements in place of conventional electrolyte solutions or electrolytes.

Next, an example of an embodiment of a photoelectric conversion element using the above-described electrolyte composition will be explained. FIG. 1 is a cross-sectional view showing an example of a schematic structure of a dye-sensitized solar cell, as an embodiment of the photoelectric conversion element of the present invention.

This dye-sensitized solar cell 1 includes a transparent electrode substrate 2, a working electrode 6 having an oxide semiconductive porous film 5 formed on the transparent electrode substrate 2 which is made of oxide semiconductive fine particles, such as titanium dioxide, and having a photo-sensitized dye absorbed thereon, and a counter electrode 8 provided opposing the working electrode 6. An electrolyte layer 7 that is made of the above-described electrolyte composition is provided between the working electrode 6 and the counter electrode 8.

The transparent electrode substrate 2 is made by forming a conductive layer 3 made of a conductive material on a transparent substrate 4, such as a glass plate or a plastic substrate.

The transparent substrate 4 is preferably made of a material having excellent optical transmittance when taking its application into consideration. Other than glass, transparent plastic substrates made of polyethylene terephthalate (PET), polyethylene naphthalate (PEN), polycarbonate (PC), polyether sulfone (PES), or the like; a polished plate of a ceramic, such as titanium oxide, alumina, or the like, may be used.

For the conductive layer 3, it is preferable that transparent oxide semiconductors, such as tin-doped indium oxide (ITO), tin oxide (SnO₂), fluorine-doped tin oxide (FTO), or the like, be used either alone or in a mixture of two or more thereof when taking the light transmittance of the transparent electrode substrate 2 into consideration. However, these materials are not limiting, and any suitable material having light transmittance and conductivity appropriate for an intended purpose may be used. Furthermore, in order to improve the current collecting efficiency from the oxide semiconductor porous film 5 or the electrolyte layer 7, a metal wiring layer made of gold, silver, platinum, aluminum, nickel, titanium, or the like, may be used provided that an area ratio of the metal wiring layer is within the range that does not significantly reduce the light transmittance of the transparent electrode substrate 2. When such a metal wiring layer is used, the metal wiring layer may be provided as a grid-like, stripe-like, or comb-like pattern so that light transmits through the transparent electrode substrate 2 as evenly as possible.

The method used to form the conductive layer 3 is not particularly limited, and any known method may be used. Examples thereof include thin layer formation methods, such as a sputtering method, or a CVD method, or a spray pyrolysis deposition (SPD), or a vacuum deposition method, when the conductive layer 3 is formed from an oxide semiconductor, such as ITO. The conductive layer 3 is formed to a thickness of between about 0.05 µm and 2.0 µm considering the optical transmittance and the conductivity.

The oxide semiconductor porous film 5 is a porous thin layer with a thickness between about 0.5 and 50 µm containing as a main component oxide semiconductor fine particles that are made of titanium oxide (TiO₂), tin oxide (SnO₂), tungsten oxide (WO₃), zinc oxide (ZnO), and niobium oxide (Nb₂O₅), used either alone or in a combination of two or more materials, and have an average particle diameter between 1 nm to 1000 nm.

The oxide semiconductor porous film 5 can be formed, for example, by employing methods such as a method in which a dispersion solution obtained by dispersing commercially available oxide semiconductor fine particles in a desired dispersion medium is coated, or a colloidal solution that can be prepared using a sol-gel method is coated, after desired additives have been added thereto if these are required, using a known coating method such as a screen printing method, an inkjet printing method, a roll coating method, a doctor-blade method, a spin coating method, a spray coating method, or the like. Other methods include: an electrophoretic deposition method in which the electrode substrate 2 is immersed in a colloidal solution and oxide semiconductor fine particles are made to adhere to the electrode substrate 2 by electrophoresis; a method in which a foaming agent is mixed in a colloidal solution or dispersion solution which is then coated and baked so as to form a porous material; and a method in which polymer microbeads are mixed together and coated on, and these polymer microbeads are then removed by thermal treatment or chemical treatment, so as to define spaces and thereby form a porous material.

The sensitizing dye that is absorbed on the oxide semiconductor porous film 5 is not particularly limited, and it is possible to use ruthenium complexes or iron complexes containing a ligand having bipyridine structures, terpyridine structures, and the like; metal complexes such as porphyrin and phthalocyanine; as well as organic dyes such as eosin, rhodamine, melocyanine, and coumarin. The dye can be selected according to the application and the material used for the oxide semiconductor porous film.

The counter electrode 8 may be one obtained by forming a thin film made of a conductive oxide semiconductor, such as ITO, FTO, or the like, on a substrate made of a non-conductive material, such as glass, or one obtained by forming an electrode by depositing or coating a conductive material, such as gold, platinum, a carbon-based material, and the like, on a substrate. Furthermore, the counter electrode 8 may be one obtained by forming a layer of platinum, carbon, or the like, on a thin layer of a conductive oxide semiconductor, such as ITO, FTO, or the like.

A method for forming the counter electrode 8 includes, forming a platinum layer by applying chloroplatinate salt and then performing a heat treatment, for example. Alternatively, a method may be used in which the electrode is formed on a substrate by a deposition technique or sputtering technique.

The electrolyte composition including ionic liquid including dicyanamide anions as anions is filled between the working electrode 6 and the counter electrode 8, thereby the electrolyte layer 7 is formed.

According to the photoelectric conversion element of this embodiment, since the main component of the electrolyte composition is the ionic liquid including dicyanamide anions as anions, it can achieve both a higher current characteristic and a higher voltage characteristic and therefore provides a better photoelectric conversion characteristic when compared with conventional ionic liquids.

### Examples

### Synthesis of ionic liquid

### 1. Synthesis of 1-ethyl-3-methylimidazolium dicyanamide

A conventional method was employed to react 1-methylimidazole with ethylbromide to obtain 1-ethyl-3-methylimidazolium bromide. It was purified by recrystallization technique and then was mixed with sodium dicyanamide in acetone for performing anion exchange, thereby synthesizing the ionic liquid according to the following formula 1. The resultant 1-ethyl-3-methylimidazolium dicyanamide was used for preparing an electrolyte solution after being purified using a silica column.

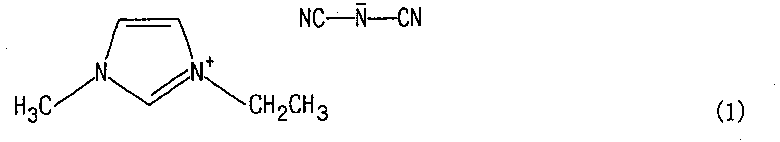

### 2. Synthesis of 1-butylpyridinium dicyanamide

A conventional method was employed to react pyridine with butylbromide to obtain 1-butylpyridinium bromide. It was purified by recrystallization technique and then was mixed with sodium dicyanamide in acetone for performing anion exchange, thereby synthesizing the ionic liquid according to the following formula 2. The resultant 1-butylpyridinium- dicyanamide was used for preparing an electrolyte solution after being purified using a silica column.

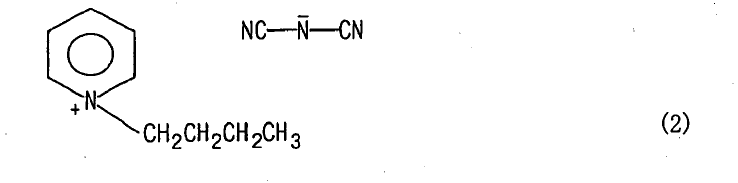

### 3. Synthesis of 1-ethyl-3-methylimidazolium bis(trifluoromethylsulfonyl)imide

A conventional method was employed to react 1-methylimidazole with ethylbromide to obtain 1-ethyl-3-methylimidazolium bromide. It was purified by recrystallization technique and then was mixed with lithium bis(trifluoromethylsulfonyl)imide in water for performing anion exchange, thereby synthesizing the ionic liquid according to the following formula 3. The resultant 1-ethyl-3-methylimidazolium bis(trifluoromethylsulfonyl)imide was used for preparing an electrolyte solution after being purified by sufficiently washing using pure water.

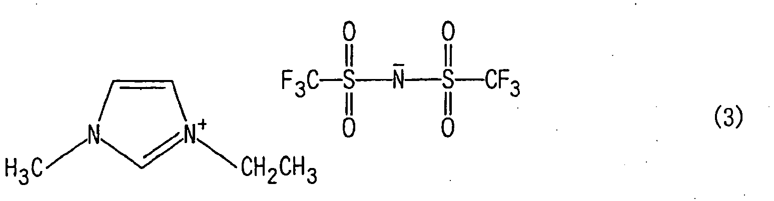

### 4. 1-Hexyl-3-methylimidazolium iodide

A commercially available 1-hexyl-3-methylimidazolium iodide according to the following formula 4 was purchased and used.

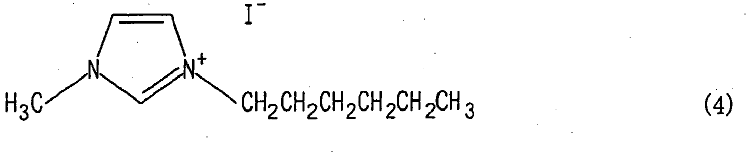

### Preparation of electrolyte composition

Electrolyte compositions according to Numbers 1 to 7 were prepared by mixing the ionic liquids, redox pair, and other additives according to the compositions listed in Table 1.

In Table 1, the following abbreviations are used:
- EMIm-DCA:: 1-ethyl-3-methylimidazolium dicyanamide
- BP y -DCA:: 1-butylpyridinium dicyanamide
- EMIm-TFSI:: 1-ethyl-3-methylimidazolium bis(trifluoromethylsulfonyl)imide
- HMIm-I:: 1-hexyl-3-methylimidazolium iodide
- EMIm-I:: 1-ethyl-3-methylimidazolium iodide
- TBP:: 4-*tert*-butylpyridine
- LiI:: lithium iodide

Furthermore, in the electrolyte composition of Number 2, poly(vinylidene fluoride-co-propene hexafluoride) was used as the gelator.

**Table 1**

| No. | Ionic Liquid | Redox pair | Additive |
|---|---|---|---|
| 1 | EMIm-DCA | EMIm-I (1.5 M) + I₂ (0.15 M) | TBP + LiI |
| 2 | EMIm-DCA | EMIm-I (1.5 M) + I₂ (0.15 M) | TBP + LiI + gelator |
| 3 | BPy-DCA | EMIm-I (1M) + I₂ (0.1M) | none |
| 4 | BPy-DCA | EMIm-I (1.5 M) + I₂ (0.15 M) | TBP + LiI |
| 5 | EMIm-TFSI | EMIm-I (1.5 M) + I₂ (0.15 M) | TBP + LiI |
| 6 | EMIm-TFSI | EMIm-I (1.5 M) + I₂ (0.15 M) | none |
| 7 | HMIm-I | HMIm-I + I₂ (mixed at a ratio of 10:1) | TBP + LiI |

### Preparation of test cells

A slurry containing titanium oxide nanoparticles of a particle size of between 13 nm to 20 nm was coated on a glass substrate having an FTO layer formed thereon, and dried, and then sintered at 450°C for one hour to form an oxide semiconductive porous film. Dye was absorbed on the oxide semiconductive porous film by immersing the substrate overnight in a solution containing the dye to prepare a photoelectrode. A ruthenium bipyridine complex (an N3 dye) was used as the dye.

Using the above-described dye-coated electrode as the working electrode, and a glass substrate having an FTO layer with Pt layer, which was prepared by the sputtering technique, was used as the counter electrode opposing the working electrode.

The working electrode and the counter electrode were overlapped each other, and the electrolyte solution was filled between the electrodes to form a dye-sensitized solar cell that was a test cell.

### Evaluation of test cells

The photoelectric conversion characteristics of the test cells were evaluated under photoirradiation conditions with an air mass (AM) 1.5 and an irradiance of 100 mW/cm². The evaluation results are listed in Table 2. In Table 2, the test cells of Numbers 1 to 4 represent working examples employing the electrolyte composition according to the present invention whereas the test cells of Numbers 5 to 7 represent comparative examples employing conventional electrolyte compositions.

**Table 2**

| No. | Photoelectric Conversion Efficiency (%) |
|---|---|
| 1 | 5.5 |
| 2 | 5.4 |
| 3 | 5.5 |
| 4 | 6.1 |
| 5 | 4.5 |
| 6 | 3.2 |
| 7 | 4.3 |

As shown in Table 2, the test cells of the working examples (Numbers 1 to 4) provided higher conversion efficiencies than test cells of the comparative examples (Numbers 5 to 7).

From the above comparison results, it is evident that photoelectric conversion elements having better output characteristics may be obtained according to the present invention.

### INDUSTRIAL APPLICABILITY

Since the electrolyte composition according to the present invention has excellent characteristics, it may be used for various applications as an electrolyte.

The photoelectric conversion element according to the present invention exhibits an excellent photoelectric conversion efficiency. Accordingly, a solar cell, such as dye-sensitized solar cell or the like using such a photoelectric conversion element is especially effective.

## Claims

1. A dye-sensitized solar cell (1) comprises an electrolyte composition as electrolyte in which the electrolyte composition comprises ionic liquid and a redox couple, **characterized in that** the ionic liquid includes dicyanamide anions as anions and cations having quaternized nitrogen atom, and that the redox couple is a halogen type redox couple obtained by reacting halogen molecules with halide ions, and that the cations are selected from a group consisting of quaternary ammonium, pyridinium with quaternized nitrogen atom, and pyrrolidinium with quaternized nitrogen atom.

2. The dye-sensitized solar cell (1) according to claim 1, **characterized in that** substituent group combined to the quaternized nitrogen atom is selected from a group consisting of alkyl group, cycloalkyl group, aryl group, and aralkyl group.

3. The dye-sensitized solar cell (1) according to claim 1, **characterized in that** the cations are pyridinium with quaternized nitrogen atom.

4. The dye-sensitized solar cell (1) according to claim 1, further comprises a working electrode (6), and a counter electrode (8), and the electrolyte (7) is provided between the working electrode (6) and the counter electrode (8).

5. The dye-sensitized solar cell (1) according to claim 1, **characterized in that** the dicyanamide anion is one or more selected from the group consisting of N-butylpiridinium dicyanamide, N-ethyl-N-methyl pyridinium dicyanamide, N-propyl-N-methyl pyridinium dicyanamide, N-hexyl-N-methyl pyridinium dicyanamide, N-pentyl-N, N, N-triethyl ammonium dicyanamide, N-hexyl-N, N, N-triethyl ammonium dicyanamide, N-pentyl-N, N, N-tributyl ammonium dicyanamide.

6. The electrolyte according to claim 1, **characterized in that** the ionic liquid includes dicyanamide anions selected from the group consisting of N-butylpyridinium dicyanamide, N-ethyl-N-methyl pyridinium dicyanamide, N-propyl-N-methyl pyridinium dicyanamide, N-hexyl-N-methyl pyridinium dicyanamide, N-pentyl-N, N, N-triethyl ammonium dicyanamide, N-hexyl-N, N, N-triethyl ammonium dicyanamide, N-pentyl-N,N,N-tributyl ammonium dicyanamide as anions.

## Patentansprüche

1. Eine farbstoffsensibilisierte Solarzelle (1), umfassend eine Elektrolytzusammensetzung als Elektrolyt, wobei die Elektrolytzusammensetzung ionische Flüssigkeit und ein Redoxpaar umfasst, **dadurch gekennzeichnet, dass** die ionische Flüssigkeit Dicyanamid-Anionen als Anionen und Kationen mit einem quaternisierten Stickstoffatom einschließt, und dass das Redoxpaar ein Redoxpaar vom Halogentyp ist, erhalten durch Umsetzen von Halogenmolekülen mit Halogenidionen, und dass die Kationen ausgewählt sind aus der Gruppe bestehend aus quaternärem Ammonium, Pyridinium mit quaternisiertem Stickstoffatom, und Pyrrolidinium mit quaternisiertem Stickstoffatom.

2. Die farbstoffsensibilisierte Solarzelle (1) gemäß Anspruch 1, **dadurch gekennzeichnet, dass** die mit dem quaternisiertem Stickstoffatom verbundene Substituentengruppe ausgewählt ist aus einer Gruppe bestehend aus einer Alkylgruppe, Cycloalkylgruppe, Arylgruppe und Aralkylgruppe.

3. Die farbstoffsensibilisierte Solarzelle (1) gemäß Anspruch 1, **dadurch gekennzeichnet, dass** die Kationen Pyridinium mit quaternisiertem Stickstoffatom sind.

4. Die farbstoffsensibilisierte Solarzelle (1) gemäß Anspruch 1, ferner umfassend eine Arbeitselektrode (6) und eine Gegenelektrode (8), und wobei der Elektrolyt (7) zwischen der Arbeitselektrode (6) und der Gegenelektrode (8) bereitgestellt ist.

5. Die farbstoffsensibilisierte Solarzelle (1) gemäß Anspruch 1, **dadurch gekennzeichnet, dass** das Dicyanamid-Anion eines oder mehrere ausgewählt aus der Gruppe bestehend aus N-butylpyridinium dicyanamid, N-Ethyl-N-methyl pyridinium dicyanamid, N-Propyl-N-methyl pyridinium dicyanamid, N-Hexyl-N-methyl pyridinium dicyanamid, N-Pentyl-N,N,N-triethyl ammonium dicyanamid, N-Hexyl-N,N,N-triethyl ammonium dicyanamid, N-Pentyl-N,N,N-tributyl ammonium dicyanamid ist.

6. Der Elektrolyt gemäß Anspruch 1, **dadurch gekennzeichnet, dass** die ionische Flüssigkeit Dicyanamid-Anionen ausgewählt aus der Gruppe bestehend aus N-butylpyridinium dicyanamid, N-Ethyl-N-methyl pyridinium dicyanamid, N-Propyl-N-methyl pyridinium dicyanamid, N-Hexyl-N-methyl pyridinium dicyanamid, N-Pentyl-N,N,N-triethyl ammonium dicyanamid, N-Hexyl-N,N,N-triethyl ammonium dicyanamid, N-Pentyl-N,N,N-tributyl ammonium dicyanamid als Anionen einschließt.

## Revendications

1. Cellule solaire à colorant (1) comprenant une composition d'électrolyte en tant qu'électrolyte dans laquelle la composition d'électrolyte comprend un liquide ionique et un couple redox, **caractérisée en ce que** le liquide ionique inclut des anions dicyanamide en tant qu'anions et des cations ayant un atome d'azote quaternisé, et **en ce que** le couple redox est un couple redox de type halogène obtenu en faisant réagir des molécules d'halogène avec des ions halogénure, et **en ce que** les cations sont choisis dans un groupe consistant en l'ammonium quaternaire, le pyridinium avec atome d'azote quaternisé, et le pyrrolidinium avec atome d'azote quaternisé.

2. Cellule solaire à colorant (1) selon la revendication 1, **caractérisée en ce que** le groupe substituant combiné à l'atome d'azote quaternisé est choisi dans un groupe consistant en un groupe alkyle, un groupe cycloalkyle, un groupe aryle, et un groupe aralkyle.

3. Cellule solaire à colorant (1) selon la revendication 1, **caractérisée en ce que** les cations sont des pyridiniums avec atome d'azote quaternisé.

4. Cellule solaire à colorant (1) selon la revendication 1, comprenant en outre une électrode de travail (6), et une contre-électrode (8), et l'électrolyte (7) est ménagé entre l'électrode de travail (6) et la contre-électrode (8).

5. Cellule solaire à colorant (1) selon la revendication 1, **caractérisée en ce que** l'anion dicyanamide est un ou plusieurs éléments choisis dans le groupe consistant en le dicyanamide de N-butylpiridinium, le dicyanamide de N-éthyl-N-méthyl pyridinium, le dicyanamide de N-propyl-N-méthyl pyridinium, le dicyanamide de N-hexyl-N-méthyl pyridinium, le dicyanamide de N-pentyl-N,N,N-triéthyl ammonium, le dicyanamide de N-hexyl-N,N,N-triéthyl ammonium, le dicyanamide de N-pentyl-N,N,N-tributyl ammonium.

6. Electrolyte selon la revendication 1, **caractérisé en ce que** le liquide ionique inclut des anions dicyanamide choisis dans le groupe consistant en le dicyanamide de N-butylpyridinium, le dicyanamide de N-éthyl-N-méthyl pyridinium, le dicyanamide de N-propyl-N-méthyl pyridinium, le dicyanamide de N-hexyl-N-méthyl pyridinium, le dicyanamide de N-pentyl-N,N,N-triéthyl ammonium, le dicyanamide de N-hexyl-N,N,N-triéthyl ammonium, le dicyanamide de N-pentyl-N,N,N-tributyl ammonium en tant qu'anions.
